# EUROPÄISCHE PATENTSCHRIFT

(11) **EP 2 058 107 B1**
(45) Veröffentlichungstag und Bekanntmachung des Hinweises auf die Patenterteilung: **08.08.2012**
(21) Anmeldenummer: 07021676.7
(22) Anmeldetag: 08.11.2007
(51) Int. Cl.: B29C 59/02, G03F 7/00

(54) **Vorrichtung zum gleichmäßigen Strukturieren von Substraten**
Device for uniformly structuring substrates
Dispositif destiné à la structuration homogène de substrats

(43) Veröffentlichungstag der Anmeldung: 13.05.2009
(60) Teilanmeldung: 12151884.9
(73) Patentinhaber: EV Group E. Thallner GmbH, 4782 St. Florian (AT)
(72) Erfinder: Linder, Friedrich Paul, 4780 Schärding (AT); Glinsner, Thomas, 4782 St. Florian/Inn (AT); Wimplinger, Markus, 4910 Ried im Innkreis (AT)
(74) Vertreter: Schweiger, Johannes

(56) Entgegenhaltungen:
- EP-A- 1 480 077
- WO-A-03/065120
- DE-U1- 20 122 179
- US-A1- 2004 192 041
- US-A1- 2005 087 911
- US-A1- 2005 260 295
- US-A1- 2006 266 734
- US-A1- 2007 158 866

## Beschreibung

Die Erfindung betrifft eine Vorrichtung zur Übertragung einer Struktur, insbesondere einer Mikro- oder Nanostruktur, von einem Stempel auf eine Flachseite eines flächigen Substrats mit einem das Substrat auf einer Substrataufnahmefläche aufnehmenden Substrathalter, einer parallel zur Substrataufnahmefläche ausrichtbaren und gegenüberliegend zu dieser anordenbaren Strukturfläche des Stempels und einer orthogonal zur Substrataufnahmefläche wirkenden Aktuatoreinrichtung.

Die Strukturierung von Substraten, beispielsweise Wafern, erfolgt durch Prägen oder Stempeln, wobei entweder mit einem Stempel gearbeitet wird, dessen Stempelsturkurfläche der Größe der zu strukturierenden Fläche auf dem Substrat entspricht, oder kleinere Stempel verwendet werden, die eine sich wiederholende Struktur in mehreren Schritten im sogenannten Step-and-Repeat-Verfahren auf das Substrat aufbringen. Während große Stempel kostspielig und schwierig herzustellen sind, dauert der Stempelvorgang bei sehr kleinen Stempeln auf Grund der mehrfach erforderlichen Ausrichtung und der vielen Zwischenschritte erheblich länger. Darüber hinaus sind große Stempel insbesondere im Nanometerbereich nur bei sehr ebenen Substraten einsetzbar. Beim Step-and-Repeat-Verfahren stellt sich das zusätzliche Problem, dass insbesondere bei runden Substraten und eckigen Stempeln bestimmte Bereiche des Substrates vom Stempel nicht erfasst werden und entsprechender Ausschuss produziert wird. Je vollständiger die verfügbare Substratoberfläche strukturiert werden kann, desto höher ist die Randausbeute, auch Edge Die Yield genannt.

Eine optimale Randausbeute würde durch Reduzierung der Stempelgröße auf Chipabmessungen, d.h. eine in sich geschlossene Struktur, erreicht werden. Typische Chipgrößen sind beispielsweise 100 µm x 100 µm bis 80 mm x 80 mm. Beim Einsatz solch kleiner Stempel würde der Durchsatz sinken und damit würden die Produktionskosten von Chips erheblich steigen.

Größte Probleme bereiten Stempel mit einer asymmetrischen Stempelstruktur, auch asymmetrischer Füllfaktor genannt, da der Stempel beim Prägen des Substrats kippen und/oder driften kann und eine ungleichmäßige Strukturierung, im schlechtesten Fall mit der Folge des Ausschusses, die Folge ist.

Die DE 201 22 179 betrifft eine Vorrichtung zum automatischen Abgeben von Flüssigkeit für Prägelithographieprozesse, bei der eine Lücke zwischen dem Substrat und einer Schablone mit Flüssigkeit angefüllt wird. Die WO-A-03/0651120 offenbart eine Vorrichtung nach dem Oberbegriff des Anspruchs 1.

Hier setzt die Erfindung an, deren Aufgabe es ist, die gattungsgemäßen Vorrichtungen dahingehend zu verbessern, dass mit kostengünstig herstellbaren Stempeln bei möglichst hohem Durchsatz und möglichst guter Randausbeute eine homogene Struktur ohne Ausschuss auf Substrate aufgebracht werden kann.

Diese Aufgabe wird mit den Merkmalen des Anspruchs 1 gelöst. Vorteilhafte Weiterbildungen der Erfindung sind in den Unteransprüchen angegeben. In den Rahmen der Erfindung fallen auch sämtliche Kombinationen aus zumindest zwei der in der Beschreibung, den Ansprüchen und/oder den Zeichnungen angegebenen Merkmale.

Der Erfindung liegt der Gedanke zu Grunde, eine Vorrichtung anzugeben, mit der die durch den Stempel auf die Substratoberfläche wirkende resultierende Kraft entlang der Stempelfläche verschoben werden kann.

Durch diese Maßnahme ist es zum einen möglich, die Stempelkraft auch bei Stempeln mit asymmetrischem Füllfaktor optimal einzuleiten und Driften oder Kippen oder Verkeilen des Stempels zu vermeiden. Zum anderen ergibt sich durch eine solche Vorrichtung die Möglichkeit, den Stempel auch am Rand des Substrates überlappend einzusetzen, wodurch die Randausbeute bis auf 100 % erhöht werden kann.

Stempeln im Sinne der vorliegenden Erfindung umfasst auch Prägen. Mit dem Begriff Nanostruktur sind Strukturen < 1 µm durchschnittlichen Abstands zwischen einzelnen Erhebungen der Substratstruktur bzw. Stempelstruktur gemeint, also auch Strukturen < 1 Nanometer. Es ist aber auch denkbar, Strukturen < 5 mm zu verarbeiten.

Die gattungsgemäße Vorrichtung wird erfindungsgemäß so ausgestaltet, dass die Aktuatoreinrichtung mindestens zwei getrennt ansteuerbare und /oder regelbare Aktuatoren zur Beaufschlagung des Stempels oder Substrats mit einer der Übertragung der Nanostruktur dienenden und orthogonal zur Substrataufnahmefläche resultierenden Kraft Fa aufweist.

Durch diese Maßnahme ist einerseits eine parallele Positionierung des Stempels vor jedem Stempel- bzw. Prägevorgang möglich, wobei die Regelung der Aktuatoren positionsgeregelt oder kraftgeregelt erfolgen kann. Die Positionsregelung kann durch einen Schrittmotor erfolgen, während die Kraftregelung durch Messung der an jedem Aktuator anliegenden Kraft erfolgen kann.

Die Topographie des Stempels bzw. der Füllfaktor des Stempels wird vor dem Stempelvorgang gemessen, um die Aktuatoren entsprechend anzusteuern und die resultierende Kraft Fa auf die Substratfläche vorzugeben. Solche asymmetrischen Strukturen kommen beispielsweise beim Hot Embossing oder UV-Prägen vor.

Durch die erfindungsgemäße Ausgestaltung kann die Kraft der Aktuatoren exakt in den Flächenschwerpunkt der wirksamen Stempelfläche gelegt werden, wodurch eine gleichmäßige Prägung/Stempelung erreicht wird, auch wenn nur Teilbereiche des Stempels zum Einsatz kommen.

Ein optimales Verhältnis zwischen Durchsatz und Stempelkosten wird durch Anpassung der Stempelgröße auf 1/1 bis 1/5500000, vorzugsweise 1/10 bis 1/50 der zu strukturierenden Substratfläche erreicht, wobei diese Anpassung unter anderem von der jeweiligen Anwendung abhängt. Bei kleinen Substraten, wie beispielsweise Hard Disks, ist 1/1 ideal, während bei großen Substraten, wie beispielsweise für LCD-Bildschirme, 1/5500000 optimal ist.

Die Aktuatoreinrichtung kann, wie vorstehend beschrieben, die Kraft auf den Stempel direkt oder indirekt ausüben, wobei das Substrat auf der in Stempelrichtung starren Substrataufnahmefläche aufliegt. Umgekehrt kann die Aktuatoreinrichtung aber auch auf die Substrataufnahmefläche wirken, während der Stempel in Stempelrichtung fixiert ist.

Die resultierende, durch die Aktuatoren auf den Stempel wirkende Kraft kann durch Veränderung der jeweils am einzelnen Aktuator anliegenden Kraft Fn beliebig auf der Strecke zwischen den Aktuatoren verschoben werden. Beim Einsatz zweier Aktuatoren kann durch parallel geführte Verschiebung der Aktuatoren jede beliebige Stelle des Stempels mit der resultierenden Kraft beaufschlagt werden.

Besonders vorteilhaft ist es dabei, dass an den Aktuatoren jeweils getrennt gesteuerte und/oder geregelte Zug- und/oder Druckkräfte Fn einstellbar sind. Hierdurch können die Stempel- und Lösekräfte genau dosiert werden.

Eine zentrale Steuerung und Einstellung bzw. Vorgabe von Werten ist möglich, wenn Aktuatoren durch eine mit den Aktuatoren über Steuerleitungen verbundene zentrale Steuereinrichtung steuerbar sind.

In besonders vorteilhafter Ausgestaltung der Erfindung weist die Aktuatoreinrichtung drei getrennt ansteuerbare und/oder regelbare Aktuatoren auf. Somit können allein durch die Steuerung der Zug-und/oder Druckkräfte die resultierende Kraft bzw. die Verhältnisse der einzelnen Zug- und/oder Druckkräfte Fn über der Stempelfläche verschoben und dosiert werden.

Eine optimale Verteilung der durch die Aktuatoren erzeugten Zug-und/oder Druckkräfte auf den Stempel wird erreicht, indem die Aktuatoreinrichtung einen die Zug- und/oder Druckkräfte Fn auf den Stempel übertragenden, insbesondere den Stempel zentral aufnehmenden, Stempelhalter aufweist.

Weiterhin ist es vorteilhaft für die Berechnung der Kräfteverteilung, die Aktuatoren am Umfang des Stempelhalters gleichmäßig verteilt anzuordnen, insbesondere mit einem Zwischenwinkel α von jeweils 120° zwischen benachbarten Aktuatoren.

Analog gilt Vorgenanntes auch bei Anordnung der Aktuatoreinrichtung am Substrathalter.

Die gesamte Strukturfläche des Stempels kann mit der resultierenden Kraft Fa erreicht werden, indem die Aktuatoren außerhalb der Strukturfläche fluchten, d.h. die durch die Strukturfläche gebildete Ebene außerhalb der Strukturfläche schneiden.

Durch eine innerhalb der Vorrichtung vorgesehene Justiereinrichtung zur translatorischen und rotatorischen Ausrichtung des Substrats parallel zu dem Stempel kann die Ausrichtung und Verschiebung des Substrats zum Stempel, insbesondere nach jedem Stempelvorgang erfolgen.

Besonders vorteilhaft ist es, die Justiereinrichtung, den Substrathalter und den Stempel zwischen einer unteren Grundplatte und einer zur unteren Grundplatte parallel ausgerichteten Stempelgrundplatte anzuordnen. Hierdurch wird die parallele Ausrichtung von Substrat und Stempel und die orthogonale Ausrichtung von Aktuatoren zum Stempel erleichtert.

Die Aktuatoren können dabei mit Vorteil die Stempelgrundplatte durchsetzen und in dieser orthogonal zur Stempelgrundplatte geführt sein.

Die Messung der Druck- und/oder Zugkräfte der Aktuatoren erfolgt mit Vorteil durch zwischen Stempel oder Substrat und jedem der Aktuatoren vorgesehene Kraftmesszellen, Dehnungsstreifen oder Widerstandsmesszellen.

Mit Vorteil sind die Kraftmesszellen über Steuerleitungen mit der zentralen Steuereinrichtung verbunden und die zentrale Steuereinrichtung ist die Aktuatoren mit dem jeweils dem Aktuator zugeordneten Messwert der korrespondierenden Kraftmesszelle steuernd und/oder regelnd ausgebildet. Die Verwendung von mindestens drei Kraftmesszellen, je eine für jeden Aktuator, erlaubt ein Ausbalancieren der Stempelkraft während des Stempelns oder Lösens. Durch das Ausbalancieren wird ein durch asymmetrischen Füllfaktor möglicherweise entstehender Keil oder ein Driften weiter ausgeglichen.

Die Vorrichtung kann vorteilhaft auch im Vakuum betrieben werden, wodurch mit Vorteil Lufteinschlüsse vermieden werden und eine präzisere Strukturübertrag möglich ist.

Besonders vorteilhaft ist es dabei, die resultierende Kraft Fa durch die Ansteuerung der Aktuatoreinrichtung im Flächenschwerpunkt einer Kontaktfläche zwischen Substrat und Stempel wirken zu lassen.

Optional ist auf dem Substrat auch eine Antihaftschicht vorgesehen. In diesem Fall liegt ein weiterer Vorteil der Erfindung darin, dass beim Entformen des Stempels die Zugkraft gemessen werden kann. Hierdurch lässt sich der Zustand der Antihaftschicht bestimmen. Der Verlauf der Zugkraft über eine Anzahl von Stempel-Abformprozessen lässt eine Bestimmung der Lebensdauer der Antihaftschicht und somit eine vorbeugende Wartung (Erneuerung der Schicht oder des Stempels) zu.

Weitere Vorteile, Merkmale und Einzelheiten der Erfindung ergeben sich aus der nachfolgenden Beschreibung bevorzugter Ausführungsbeispiele sowie anhand der Zeichnungen. Diese zeigen in:
- Fig. 1a:: Eine schematische Aufsicht auf die erfindungsgemäße Vorrichtung bei zentral auf den Stempel wirkender resultierender Kraft Fa und vollflächigem Einsatz des Stempels,
- Fig. 1b:: eine Seitenansicht der Vorrichtung gemäß Fig. 1a,
- Fig. 2a:: die erfindungsgemäße Vorrichtung mit dezentral auf den Stempel wirkender, resultierender Kraft Fa,
- Fig. 2b:: die erfindungsgemäße Vorrichtung gemäß Fig. 2a,
- Fig. 3:: eine isometrische Darstellung der Aktuatorkräfte und der resultierenden Gegenkraft FR,
- Fig. 4:: eine schematische Darstellung der Stempelflächen auf der Substratfläche und
- Fig. 5:: eine Seitenansicht eines Stempels mit asymmetrischem Füllfaktor.
In den Figuren sind gleiche Bauteile und Bauteile mit der gleichen Funktion mit den gleichen Bezugszeichen gekennzeichnet.

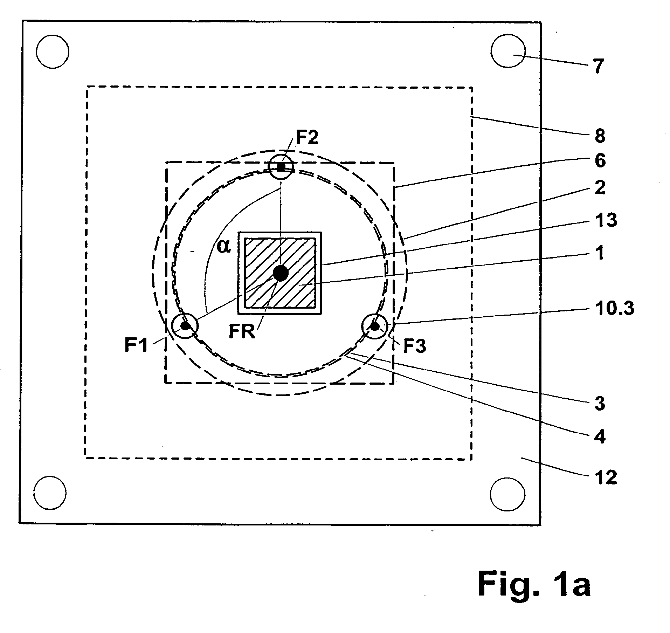

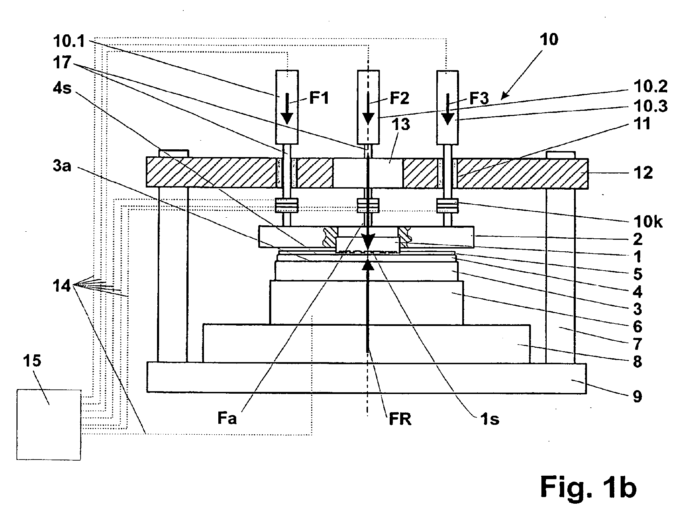

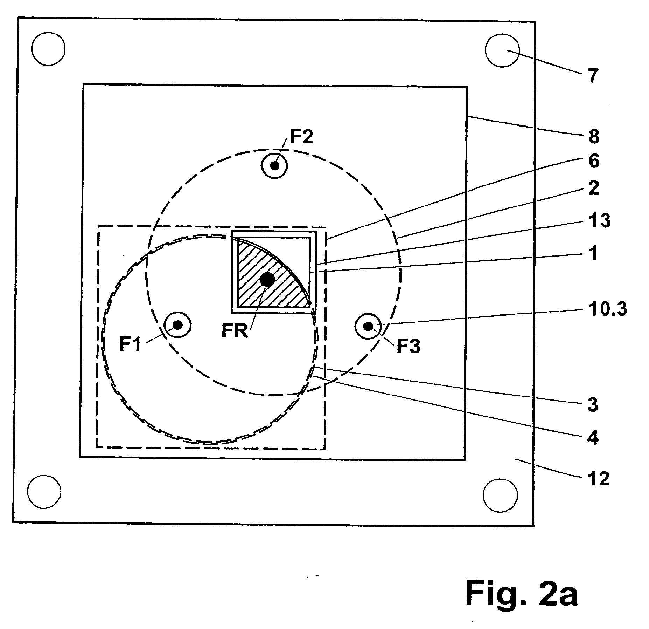

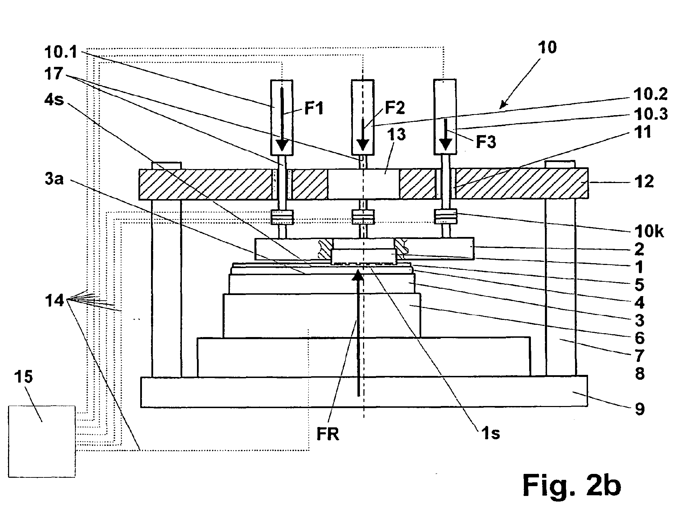

In Fig. 1a und 1b ist die erfindungsgemäße Vorrichtung in einem Stempelschritt des Step-and-Repeat-Verfahrens gezeigt, bei welchem der mittlere Bereich eines Substrats 4 geprägt wird. In Fig. 2a und 2b wird dagegen ein Randbereich (schraffiert) geprägt, weshalb in Pfeildarstellung gezeigte Druckkräfte F1, F2 und F3 von Aktuatoren 10.1, 10.2 und 10.3 ungleichmäßig verteilt sind, um eine resultierende Gegenkraft FR in einen Flächenschwerpunkt einer Kontaktfläche des Stempels 1 mit dem Substrat 4 zu verlegen.

Dagegen sind die in Fig. 1b gezeigten Druckkräfte F1, F2 und F3 gleichmäßig verteilt, da der Stempel 1 zu den Aktuatoren 10.1. 10.2 und 10.3 bzw. deren Druckübertragungsstangen 17, die an einem Stempelhalter 2 angebracht sind, der den Stempel 1 zentrisch aufnimmt, gleichmäßig beabstandet sind.

Der Stempelhalter 2 dient zum einen der Fixierung des Stempels 1 und gleichmäßigen Kraftübertragung und zum anderen ermöglicht er den einfacheren Austausch des Stempels 1, falls eine neue Nanostruktur 16 auf das Substrat 4 aufgebracht werden muss.

Die Vorrichtung und deren Bauteile werden im Wesentlichen durch eine untere Grundplatte 9 gestützt, die über vier an den Ecken der Grundplatte 9 senkrecht nach oben ragende Verbindungsträger 7 mit einer Stempelgrundplatte 12 verbunden ist, gebildet. Grundplatte 9 und Stempelgrundplatte 12 sind plan eben und parallel zueinander ausgerichtet.

Auf der Grundplatte 9 ist eine Justiertischgrundplatte 8 angeordnet, die wiederum einen Justiertisch 6 aufnimmt. Dieser sorgt für die Verschiebung der nachfolgend beschriebenen, auf dem Justiertisch 6 angeordneten Bauteile gegenüber der Justiertischgrundplatte 8 in X-Richtung, Y-Richtung und in Rotationsrichtung, d.h. in translatorischer und rotatorischer Art und Weise.

Auf dem Justiertisch 6 ist ein Substrathalter 3 fixiert, der das Substrat 4 mit einer etwaigen Polymerschicht 5 aufnimmt, wobei die Polymerschicht 5 beispielsweise über ein Fenster 13 in der Stempelgrundplatte 12 aufgebracht werden kann.

Gegenüberliegend und parallel zu dem Substrat 4 ist die Strukturfläche 1s des Stempels angeordnet und der Stempel 1 mittig in dem Stempelhalter 2 fixiert aufgenommen, der wiederum durch drei über der Fläche des Stempelhalters 2 auf der dem Stempel 1 abgewandten Seite des Stempelhalters 2 angebrachte Druckübertragungsstangen 17 gehalten wird. Die Druckübertragungsstangen 17 sind jeweils einem der drei Aktuatoren 10.1, 10.2 und 10.3 zugeordnet und in einer Führung 11 in der Stempelgrundplatte 12 orthogonal zu der Stempelgrundplatte 12 bzw. orthogonal zu dem Substrat 4 und dem Stempel 1 gleitend geführt. In jede Druckübertragungsstange 17 sind Kraftmesszellen 10k integriert, die die Zug- und/oder Druckkräfte F1, F2 und F3 messen und über Verbindungsleitungen 14 an die zentrale Steuereinrichtung 15 übertragen.

Die zentrale Steuereinrichtung 15 sorgt durch die von den Kraftmesszellen 10k erhaltenen oder abgerufenen Messwerte dafür, dass die Stempelfläche 1s des Stempels 1 mit homogenem Druck auf das Substrat 4 gepresst wird, ohne das Keil- oder Drifteffekte entstehen.

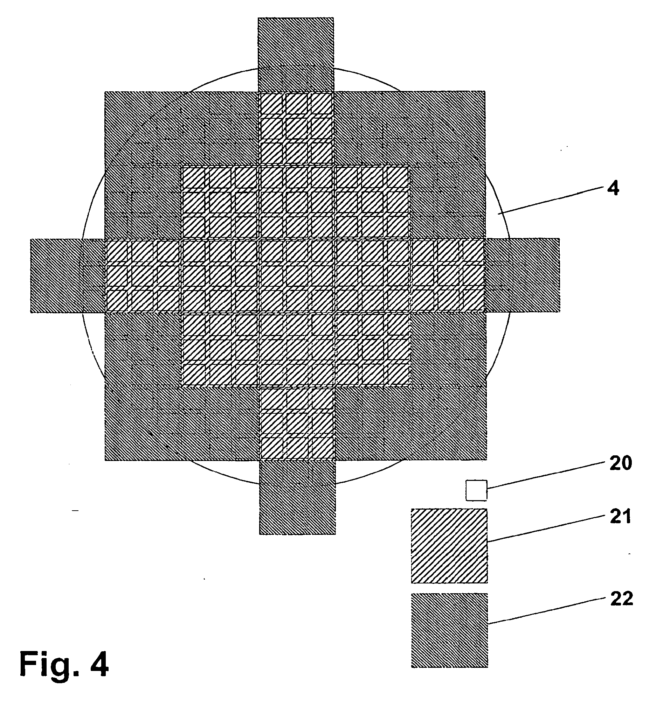

Weiterhin sorgt die zentrale Steuereinrichtung 15 für die Durchführung des Step-and-Repeat-Verfahrens, d.h. das Absenken und Anheben des Stempels 1 durch die Aktuatoreinrichtung 10, das anschließende Versetzen des Substrats 4 durch die Justiereinrichtung 6 zum nächsten, vorzugsweise benachbarten, zu bedruckenden Feld, wobei die einzelnen Felder 21, 22 aus mehreren Chips 20 bestehen können (siehe Fig. 4).

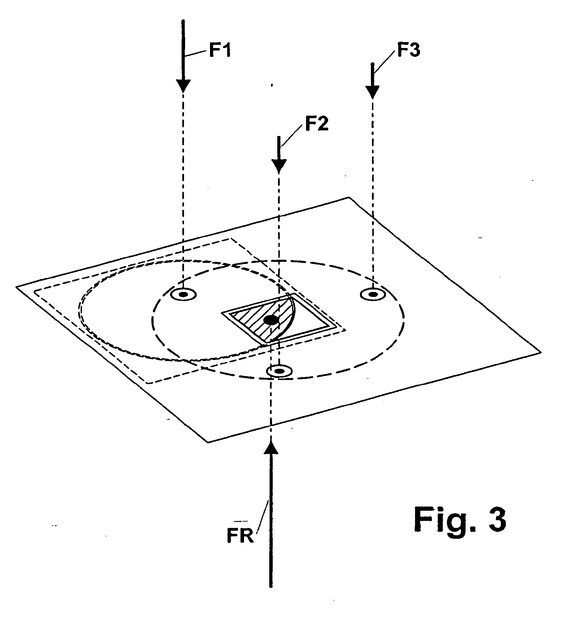

Die in Fig. 4 dunkel schraffierten Felder 22 überlappen das Substrat 4, weshalb die resultierende Kraft Fa des Stempels 1 auf die wirksame Kontaktfläche in den Flächenschwerpunkt der wirksamen Kontaktfläche zwischen der Stempelfläche 1s und einer Flachseite 4s des Substrats 4 gelegt wird. Dies ist schematisch in Fig. 3 dargestellt, wobei die Summe der durch Pfeile dargestellten Kraftvektoren F1, F2 und F3 der durch die Aktuatoren 10.1, 10.2 und 10.3 ausgeübten Druckkräfte der resultierenden Gegenkraft FR entspricht.

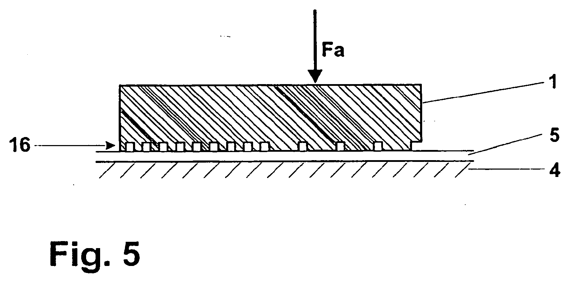

In Fig. 5 ist der Stempel 1 mit asymmetrischer Struktur 16 dargestellt. Auf Grund der asymmetrischen Struktur 16 ist die resultierende Kraft Fa in Richtung der Seite mit höherem Füllfaktor gerückt und drückt damit den Stempel 1 homogen auf die Polymerschicht 5 und das Substrat 4.

### Bezugszeichenliste

- 1: Stempel
- 1 s: Strukturfläche
- 2: Stempelhalter
- 3: Substrathalter
- 3a: Substrathalteraufnahmefläche
- 4: Substrat
- 4s: Flachseite
- 5: Polymerschicht
- 6: Justiereinrichtung
- 7: Verbindungsträger
- 8: Justiertischgrundplatte
- 9: Grundplatte
- 10: Aktuatoreinrichtung
- 10.1: Aktuator
- 10.2: Aktuator
- 10.3: Aktuator
- 10k: Kraftmesszelle
- 11: Führung
- 12: Stempelgrundplatte
- 13: Fenster
- 14: Steuerleitungen
- 15: Steuereinrichtung
- 16: asymmetrische Struktur
- 17: Druckübertragungsstangen
- 20: Chip
- 21: Feld
- 22: Feld
- F1: Druckkraft
- F2: Druckkraft
- F3: Druckkraft
- Fa: resultierende Kraft
- FR: Gegenkraft

## Patentansprüche

1. Vorrichtung zur Übertragung einer Struktur (16) von einem Stempel (1) auf eine Flachseite (4s) eines flächigen Substrats (4) mit
- einem das Substrat (4) auf einer Substrataufnahmefläche (3a) aufnehmenden Substrathalter (3),
- einer parallel zur Substrataufnahmefläche (3a) ausrichtbaren und gegenüberliegend zu dieser anordenbaren Strukturfläche (1s) des Stempels (1) und
- einer orthogonal zur Substrataufnahmefläche (3a) wirkenden Aktuatoreinrichtung (10),
**dadurch gekennzeichnet, dass**
die Aktuatoreinrichtung (10) mindestens zwei getrennt und abhängig von einer Topographie der struktur (16) oder einem Füllfaktor der Struktur (16) ansteuerbare und/oder regelbare Aktuatoren (10.1, 10.2, ... 10.n) zur Beaufschlagung des Stempels (1) oder Substrats (4) mit einer der Übertragung der Struktur (16) dienenden und orthogonal zur Substrataufnahmefläche (3a) resultierenden Kraft Fa aufweist.

2. Vorrichtung nach Anspruch 1, bei der an den Aktuatoren (10.1, 10.2 ... 10.n) jeweils getrennt gesteuerte und/oder geregelte Zugund/oder Druckkräfte (F1, F2, ... Fn) einstellbar sind.

3. Vorrichtung nach einem der vorhergehenden Ansprüche, bei der die Aktuatoren (10.1, 10.2 ... 10.n) durch eine mit den Aktuatoren (10.1, 10.2 ... 10.n) über Steuerleitungen 14 verbundene zentrale Steuereinrichtung 15 steuerbar sind.

4. Vorrichtung nach einem der vorhergehenden Ansprüche, bei der die Aktuatoreinrichtung (10) drei getrennt ansteuerbare und/oder regelbare Aktuatoren (10.1, 10.2 ... 10.n) aufweist.

5. Vorrichtung nach einem der vorhergehenden Ansprüche, bei der die Aktuatoreinrichtung (10) einen die Zug- und/oder Druckkräfte (F1, F2, ... Fn) auf den Stempel (1) übertragenden, insbesondere den Stempel (1) zentral aufnehmenden, Stempelhalter (2) aufweist.

6. Vorrichtung nach einem der vorhergehenden Ansprüche, bei der die Aktuatoren (10.1, 10.2 ... 10.n) am Umfang des Stempelhalters (2) gleichmäßig verteilt angeordnet sind, insbesondere mit einem Zwischenwinkel a von 120°.

7. Vorrichtung nach einem der Ansprüche 1 bis 4, bei der die Aktuatoreinrichtung (10) die Zug- und/oder Druckkräfte (F1, F2, ... Fn) auf den Substrathalter (3) überträgt.

8. Vorrichtung nach Anspruch 7, bei der die Aktuatoren (10.1, 10.2 ...10.n) am Umfang des Stempelhalters (2) gleichmäßig verteilt angeordnet sind, insbesondere mit einem Zwischenwinkel a von 120°.

9. Vorrichtung nach einem der vorhergehenden Ansprüche, bei der die Aktuatoren (10.1, 10.2 ... 10.n) außerhalb der Strukturfläche (1s) fluchten.

10. Vorrichtung nach einem der vorhergehenden Ansprüche, bei der eine Justiereinrichtung (6) zur translatorischen und rotatorischen Ausrichtung des Substrats (4) parallel zu dem Stempel (1) vorgesehen ist.

11. Vorrichtung nach einem der vorhergehenden Ansprüche, bei der die Justiereinrichtung (6), der Substrathalter (3) und der Stempel (1) zwischen einer unteren Grundplatte (9) und einer zur unteren Grundplatte (9) parallel ausgerichteten Stempelgrundplatte (12) angeordnet sind.

12. vorrichtung nach einem der vorhergehenden Ansprüche, bei der die untere Grundplatte (9) über, insbesondere an den Ecken der Grundplatte (9) und der Stempelgrundplatte (12) angebrachte, Verbindungsträger (7) fest mit der Stempelgrundplatte (12) verbunden ist.

13. Vorrichtung nach einem der Ansprüche 1 bis 6 und 9 bis 12, bei der die Aktuatoren (10.1, 10.2 ... 10.n) die Stempelgrundplatte (12) durchsetzen und in dieser orthogonal zur Stempelgrundplatte (12) geführt sind.

14. Vorrichtung nach einem der vorhergehenden Ansprüche, bei der zwischen Stempel (1) oder Substrat (4) und jedem der Aktuatoren (10.1, 10.2 ... 10.n) eine, insbesondere piezoelektrische, Kraftmesszelle (10k) zur Messung der Zug- und/oder Druckkräfte (F1, F2, ... Fn) vorgesehen ist.

15. vorrichtung nach Anspruch 3 und 14, bei der die Kraftmesszellen (10k) über Steuerleitungen (14) mit der zentralen Steuereinrichtung (15) verbunden sind und die zentrale Steuereinrichtung (15) die Aktuatoren (10.1, 10.2 ... 10.n) mit dem jeweils dem Aktuator (10.1, 10.2 ... 10.n) zugeordneten Messwert der korrespondierenden Kraftmesszelle (10k) steuernd und/oder regelnd ausgebildet ist.

16. Vorrichtung nach einem der vorhergehenden Ansprüche
**dadurch gekennzeichnet, dass**
die Aktuatoreinrichtung (10) im Flächenschwerpunkt einer Kontaktfläche zwischen Substrat (4) und Stempel (1) wirkend ausgebildet ist.

## Claims

1. System for transferring a structure (16) of a die (1) to a flat side (4s) of a largearea substrate (4) with
- A substrate holder (3) that receives the substrate (4) on a substrate receiving surface (3a),
- A structural surface (1s) of the die (1) that can be oriented parallel to and located opposite to the substrate receiving surface (3a) of the die (1) and
- An actuator device (10) that acts orthogonally to the substrate receiving surface (3a),
**characterized in that** the actuator device (1) has at least two separately and depending from a topography of the structure (16) or a filling factor of the structure controllable and/or regulatable actuators (10.1, 10.2, ... 10.n) for imposing on the die (1) or substrate (4) a force Fa that ensures the transfer of the structure (16) and whose resultant is orthogonal to the substrate receiving surface (3a).

2. System according to claim 1, in which in each case separately controlled and/or regulated tensile and/or compressive forces (F1, F2, ... Fn) can be adjusted on the actuators (10.1, 10.2 ... 10.n).

3. System according to one of the preceding claims, in which the actuators (10.1, 10.2 ... 10.n) can be controlled by a central control device 15 that is connected by control lines 14 to the actuators (10.1, 10.2 ... 10.n).

4. System according to one of the preceding claims, in which the actuator device (10) has three separately controllable and/or regulatable actuators (10.1, 10.2 ... 10.n).

5. System according to one of the preceding claims, in which the actuator device (10) has a die holder (2) that transfers the tensile and/or compressive forces (F1, F2, ... Fn) to the die (1), a die holder in particular receiving the die (1) in a central location.

6. System according to one of the preceding claims, in which the actuators (10. 1, 10.2 ... 10.n) are arranged uniformly distributed on the periphery of the die holder (2), in particular with an intermediate angle α of 120°.

7. System according to one of claims 1 to 4, in which the actuator device (10) transfers the tensile and/or compressive forces (F1, F2, ... Fn) to the substrate holder (3).

8. System according to claim 7, in which the actuators (10.1, 10.2 ... 10.n) are arranged uniformly distributed on the periphery of the die holder (2), in particular with an intermediate angle α of 120°.

9. System according to one of the preceding claims, in which the actuators (10.1, 10.2 ... 10.n) escape outside of the structural surface (1s).

10. System according to one of the preceding claims, in which an adjusting device (6) is provided for translatory and rotating orientation of the substrate (4) parallel to the die (1).

11. System according to one of the preceding claims, in which the adjusting device (6), the substrate holder (3) and the die (1) are arranged between a lower base plate (9) and a die base plate (12) that is oriented parallel to the lower base plate (9).

12. System according to one of the preceding claims, in which the lower base plate (9) is connected securely to the die base plate (12) via connecting supports (7) that are attached in particular to the edges of the base plate (9) and the die base plate (12).

13. System according to one of claims 1 to 6 and 9 to 12, in which the actuators (10.1, 10.2 ... 10.n) penetrate the die base plate (12) and are guided into the latter orthogonally to the die base plate (12).

14. System according to one of the preceding claims, in which a, in particular piezoelectric, force measuring cell (10k) is provided between die (1) or substrate (4) and each of the actuators (10.1, 10.2 ... 10.n) to measure the tensile and/or compressive forces (F1, F2, ... FN).

15. System according to claims 3 and 14, in which the force measuring cells (10k) are connected via control lines (14) to the central control device (15), and the central control device (15) is designed to control and/or to regulate the actuators (10.1, 10.2 ... 10.n) with the measured values of the corresponding force measuring cell (10K) that is in each case associated with the actuator (10.1, 10.2, ... 10.n).

16. System according to one of the preceding claims, **characterized in that** the actuator device (10) acts in the centroid of the area of a contact surface between substrate (4) and die (1).

## Revendications

1. Dispositif de transfert d'une structure (16) d'un tampon (1) sur une face plane (4s) d'un substrat plat (4), comportant :
- un support de substrat (3) recevant le substrat (4) sur une surface réceptrice de substrat (3a),
- une surface structurée (1s) de tampon (1) orientable parallèlement à la surface réceptrice de substrat (3a) et pouvant être disposée en face de celle-ci et
- un dispositif actionneur (10) agissant orthogonalement par rapport à la surface réceptrice de substrat (3a),
**caractérisé en ce que**
le dispositif actionneur (10) présente au moins deux actionneurs (10.1, 10.2, ... 10.n) pouvant être commandés et/ou réglés en fonction d'une topographie de la structure (16) ou d'un facteur de remplissage de la structure (16) pour appliquer au tampon (1) ou au substrat (4) une force Fa servant à transférer la structure (16) et générée orthogonalement par rapport à la surface réceptrice de substrat (3a).

2. Dispositif selon la revendication 1, dans lequel des forces de traction et/ou compression (F1, F2, ... Fn) commandées et/ou réglées respectivement séparément sont réglables au niveau des actionneurs (10.1, 10.2, ... 10.n).

3. Dispositif selon une des revendications précédentes, dans lequel les actionneurs (10.1, 10.2, ... 10.n) peuvent être commandés à l'aide d'un dispositif de commande 15 central relié aux actionneurs (10.1, 10.2, ... 10.n).

4. Dispositif selon une des revendications précédentes, dans lequel le dispositif actionneur (10) présente trois actionneurs (10.1, 10.2, ... 10.n) pouvant être commandés et/ou réglés séparément.

5. Dispositif selon une des revendications précédentes, dans lequel le dispositif actionneur (10) présente un support de tampon (2) transférant les forces de traction et/ou compression (F1, F2, ... Fn) au tampon (1), en particulier recevant le tampon (1) au centre.

6. Dispositif selon une des revendications précédentes, dans lequel les actionneurs (10.1, 10.2, ... 10.n) sont disposés répartis régulièrement sur la circonférence du support de tampon (2), en particulier avec un angle intermédiaire α de 120°.

7. Dispositif selon une des revendications 1 à 4, dans lequel le dispositif actionneur (10) transfère les forces de traction et/ou compression (F1, F2, ... Fn) au support de tampon (3).

8. Dispositif selon la revendication 7, dans lequel les actionneurs (10.1, 10.2, ... 10.n) sont disposés répartis régulièrement sur la circonférence du support de tampon (2), en particulier avec un angle intermédiaire α de 120°.

9. Dispositif selon une des revendications précédentes, dans lequel les actionneurs (10.1, 10.2, ... 10.n) sont alignés à l'extérieur de la surface structurée (1s).

10. Dispositif selon une des revendications précédentes, dans lequel un dispositif d'ajustage (6) est prévu pour l'orientation translatoire et rotatoire du substrat (4) parallèlement au tampon (1).

11. Dispositif selon une des revendications précédentes, dans lequel le dispositif d'ajustage (6), le support de substrat (3) et le tampon (1) sont disposés entre une plaque de base inférieure (9) et une plaque de base de tampon (12) orientée parallèlement à la plaque de base inférieure (9).

12. Dispositif selon une des revendications précédentes, dans lequel la plaque de base inférieure (9) est reliée fixement par des supports de raccords (7) installés en particulier aux coins de la plaque de base (9) et de la plaque de base du tampon (12).

13. Dispositif selon une des revendications 1 à 6 et 9 à 12, dans lequel les actionneurs (10.1, 10.2, ... 10.n) traversent la plaque de base du tampon (12) et passent dedans orthogonalement par rapport à la plaque de base du tampon (12).

14. Dispositif selon une des revendications précédentes, dans lequel, entre le tampon (1) ou le substrat (4) et chacun des actionneurs (10.1, 10.2, ... 10.n), une cellule de mesure de force (10k), en particulier piézoélectrique, est prévue pour mesurer les forces de traction et/ou compression (F1, F2, ... Fn).

15. Dispositif selon les revendications 3 et 14, dans lequel les cellules de mesure de force (10k) sont reliées par des câbles de commande (14) au dispositif de commande central (15) et le dispositif de commande central (15) est réalisé de manière à commander et/ou régler à la valeur de mesure associée respectivement à l'actionneur (10.1, 10.2, ... 10.n) de la cellule de mesure correspondante (10k).

16. Dispositif selon une des revendications précédentes, **caractérisé en ce que** le dispositif actionneur (10) est réalisé de manière à agir dans le centre de gravité surfacique d'une surface de contact entre le substrat (4) et le tampon (1).
